# EUROPEAN PATENT APPLICATION

(11) **EP 4 679 354 A1**
(43) Date of publication of application: **14.01.2026**
(21) Application number: 24767098.7
(22) Date of filing: 04.03.2024
(51) Int. Cl.: G06Q 50/10

(54) **BATTERY REUSE ASSISTANCE DEVICE, BATTERY REUSE ASSISTANCE TERMINAL, AND BATTERY REUSE ASSISTANCE METHOD**

(30) Priority: 07.03.2023 JP 2023034176
(71) Applicant: GS Yuasa International Ltd., Kisshoin, Minami-ku, Kyoto-shi, Kyoto 601-8520 (JP)
(72) Inventor: UKUMORI Nan, Kyoto-shi, Kyoto 601-8520 (JP)
(74) Representative: Grünecker Patent- und Rechtsanwälte PartG mbB
(86) International application number: PCT/JP2024/007981
(87) International publication number: WO 2024/185730

(57) **Abstract**

A battery reuse assistance apparatus 2 is provided with: a simulator receiving portion 24 which receives a simulator for simulating a state of a battery; a data receiving portion 25 which receives operational history data at a predetermined point of time of the battery; an execution portion 26 which simulates the state of the battery by inputting the operational history data to the simulator; a storage portion 22 which stores the state which has been simulated as a battery state file at the predetermined point of time in association with the battery; and a provision portion 27 which provides, in response to a request or as an event, the battery state file or information based on the simulator, the battery state file, and supposed reuse operational data.

## Description

### TECHNICAL FIELD

One aspect of the present invention relates to a battery reuse assistance apparatus, a battery reuse assistance terminal, and a battery reuse assistance method.

### BACKGROUND ART

Patent Literature 1 discloses an apparatus for assisting with buying and selling of used cars and transactions related thereto using a computer connected to the apparatus via a communication line such as the Internet.

### CITATION LIST

### Patent Literature

Patent Literature 1: Japanese Unexamined Patent Application Publication No. 2007-334873

### DISCLOSURE OF INVENTION

### PROBLEMS TO BE SOLVED BY THE INVENTION

For used cars and used houses, there exist trading markets in which sellers, buyers, and intermediate agents participate.

Although secondary batteries such as lithium-ion batteries are desired to be reused, there is no similar trading markets for the secondary batteries yet.

A transaction price of a used car can be determined from information which can be objectively recognized even by a third party, such as a travel distance, whether or not the car has a history of accidents, and whether or not there is damage to components or outer appearance of the car. Similarly, a transaction price can be determined for a used house.

Regarding a battery, information which can be objectively recognized by a third party who has not been involved in the operation of the battery (in what environment and how the battery has been charged and discharged) until then is extremely limited at the time of transaction for reuse. A state of health (SOH) of a battery can be ascertained by conducting a discharge test of the battery and measuring the capacity. However, there are various modes of deterioration in the battery, and it is difficult to ascertain the details of the deteriorated state only from the capacity measurement.

In addition, as regards the battery to be reused, whether or not a manufacturer of that battery should be responsible for warranty is not defined. Since a battery manufacturer is unable to know in what environment and how a battery will be charged and discharged after shipment of the battery and is also unable to know in what form the battery will be reused, it is extremely difficult for the battery manufacturer to be responsible for the warranty regarding a reused battery.

One aspect of the present invention provides a battery reuse assistance apparatus capable of promoting reuse of a battery.

### MEANS FOR SOLVING THE PROBLEMS

A battery reuse assistance apparatus according to one aspect of the present invention includes: a simulator receiving portion which receives a simulator for simulating a state of a battery; a data receiving portion which receives operational history data at a predetermined point of time of the battery; an execution portion which simulates the state of the battery by inputting the operational history data to the simulator; a storage portion which stores the state which has been simulated as a battery state file at the predetermined point of time in association with the battery; and a provision portion which provides, in response to a request or as an event, the battery state file or information based on the simulator, the battery state file, and supposed reuse operational data.

Here, the "battery state file" may be electronic data which is used together with the simulator and the supposed reuse operational data and enables simulation of a behavior the battery after reuse is started.

### EFFECT OF THE INVENTION

According to the above-described aspect, it is possible to provide a battery reuse assistance apparatus capable of promoting reuse of a battery.

### BRIEF DESCRIPTION OF DRAWINGS

FIG. 1 is a conceptual diagram of a battery reuse ecosystem (platform).
FIG. 2 is a block diagram showing the battery reuse ecosystem.
FIG. 3 is a diagram showing an example of a connection form of a communication device.
FIG. 4 is a block diagram showing an example of a configuration of a server apparatus.
FIG. 5 is a diagram illustrating an update of a battery state file.
FIG. 6 is a diagram illustrating distribution of a battery state file.

### DESCRIPTION OF EMBODIMENTS

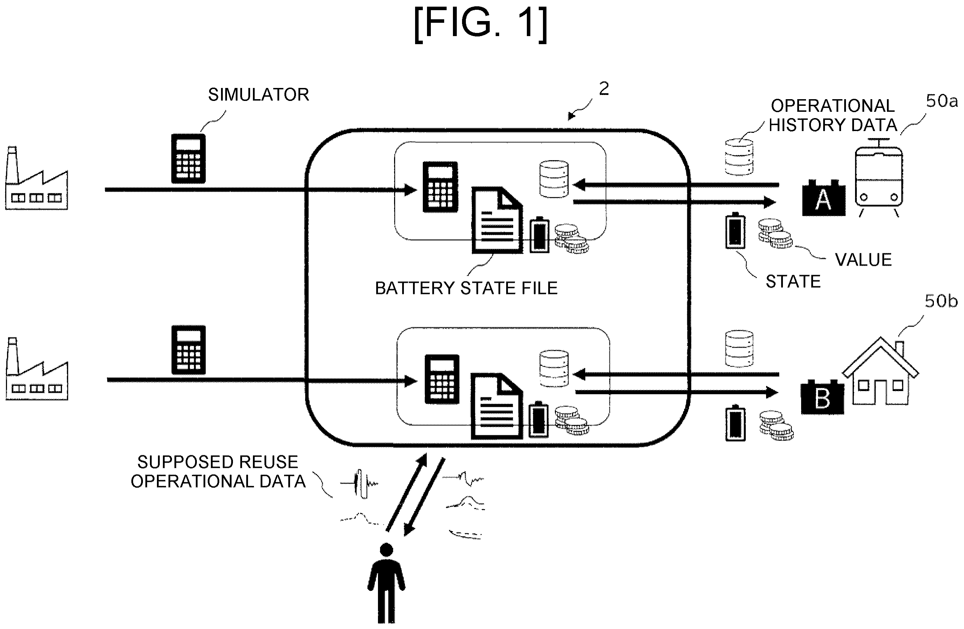

First, an outline of a battery reuse ecosystem according to an embodiment will be described. A battery A illustrated in FIG. 1 is used as a movable body energy storage apparatus 50a, and a battery B is used as a stationary energy storage apparatus 50b. An owner or an administrator (such as a remote observer) of each of the energy storage apparatuses 50a and 50b uses a communication device which will be described later to transmit time-series operational history data (a current, a voltage, a temperature, and the like, for example) of the energy storage apparatuses 50a and 50b to a battery reuse assistance apparatus 2. This transmission should preferably be performed periodically and automatically by the communication device. The stationary energy storage apparatus 50b is not limited to a home-use energy storage apparatus, but may be an energy storage system (ESS) for industrial use, public use, energy management system (EMS) use, or renewable energy use.

Manufacturers of the batteries A and B, which are illustrated on a left side of FIG. 1, transmit simulators for simulating the states of the respective batteries to the battery reuse assistance apparatus 2. The manufacturers of the batteries A and B may be the same as each other or different from each other.

For each of the batteries A and B, the battery reuse assistance apparatus 2 inputs the operational history data to the corresponding simulator and simulates the state of the battery at a predetermined point of time, and then stores the simulated state as a battery state file in association with each of the batteries A and B.

The battery reuse assistance apparatus 2 provides, in response to a request or as an event, the battery state file to the owner or the administrator of each of the energy storage apparatuses 50a and 50b which are illustrated on a right side of FIG. 1. In the present specification, the description "provides the battery state file" includes as its meaning allowing the battery state file to be available.

As a result, the owner or the administrator of each of the energy storage apparatuses 50a and 50b can grasp the state of the batteries A and B at the predetermined point of time and a value thereof in a reuse market. At this time, an evaluator which will be described later may be used.

Further, the battery reuse assistance apparatus 2 receives supposed reuse operational data from a third party (a potential purchaser, an intermediate agent, or the like) illustrated on a lower side of FIG. 1, who is not the owner or the administrator of the energy storage apparatuses 50a and 50b. The battery reuse assistance apparatus 2 provides the third party with information based on the received supposed reuse operational data, and the simulator and the battery state file that are related to the battery A and the battery B.

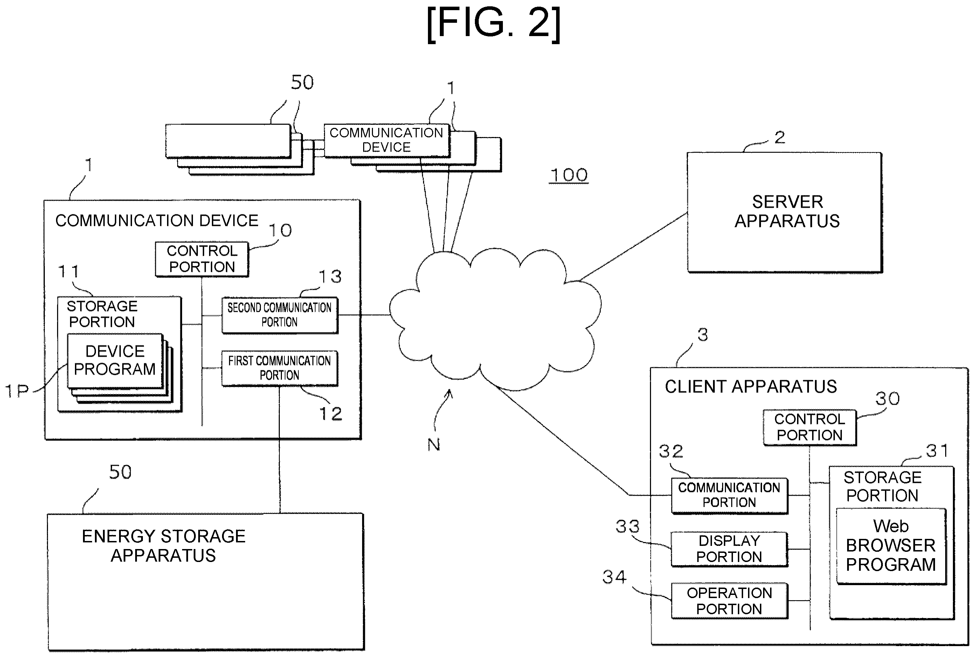

FIG. 2 is a block diagram showing an example of a configuration of a battery reuse ecosystem 100. The battery reuse ecosystem 100 is provided with a communication device 1, a server apparatus 2, a client apparatus 3, and the like. In the present embodiment, the battery reuse assistance apparatus is configured from the server apparatus 2. Alternatively, the battery reuse assistance apparatus may be configured as a blockchain system by application of a distributed ledger management technology (blockchain technology).

As illustrated in FIG. 2, the communication device 1 is connected to a network N and is also connected to an energy storage apparatus 50.

In the battery reuse ecosystem 100, by using the communication devices 1 connected to the respective energy storage apparatuses 50, the state (the current, the voltage, the temperature, a state of charge (SOC), and the like, for example) of an energy storage module and an energy storage cell are monitored and collected. Each of the communication devices 1 transmits, in response to a request from the server apparatus 2 or as an event, the collected state of the energy storage apparatus to the server apparatus 2 via the network N.

The communication device 1 includes a control portion 10, a storage portion 11, a first communication portion 12, and a second communication portion 13. The control portion 10 is constituted by a central processing unit (CPU) or the like, and controls the communication device 1 as a whole by using built-in memories such as a read-only memory (ROM) and a random-access memory (RAM).

As the storage portion 11, for example, a nonvolatile memory such as a flash memory may be used. In the storage portion 11, a device program 1P to be read and executed by the control portion 10 is stored. In the storage portion 11, pieces of information collected by processing of the control portion 10 and information such as an event log are stored.

The first communication portion 12 is a communication interface which realizes communication with the energy storage apparatus 50, and a serial communication interface such as RS-232C or RS-485, for example, may be used.

The second communication portion 13 is an interface which realizes communication via the network N, and a communication interface such as Ethernet (registered trademark) or a wireless communication antenna, for example, is used. The control portion 10 can communicate with the server apparatus 2 via the second communication portion 13.

The client apparatus 3 may be a computer used by the owner or the administrator of the energy storage apparatus 50, or by a potential purchaser or an intermediate agent, etc., of the energy storage apparatus 50. The client apparatus 3 may be a desktop or laptop personal computer, or may be a smartphone or a tablet communication terminal. The client apparatus 3 includes a control portion 30, a storage portion 31, a communication portion 32, a display portion 33, and an operation portion 34.

The control portion 30 is a processor using a CPU. The control portion 30 causes the display portion 33 to display a web page, which is provided by the server apparatus 2 or the communication device 1, on the basis of a Web browser program stored in the storage portion 31.

As the storage portion 31, for example, a nonvolatile memory such as a hard disk or a flash memory is used. Various programs including the Web browser program are stored in the storage portion 31.

As the communication portion 32, a communication device such as a network card for wired communication, a wireless communication device for mobile communication to establish connection to a base station, or a wireless communication device adapted to connect to an access point may be used. The control portion 30 can communicably connect with or transmit information to or receive information from the server apparatus 2 or the communication device 1 via the network N by way of the communication portion 32.

As the display portion 33, a display such as a liquid crystal display or an organic electroluminescence (EL) display may be used. The display portion 33 can display an image of a web page provided by the server apparatus 2 by processing of the control portion 30 that is based on the Web browser program.

The operation portion 34 is a user interface such as a keyboard and a pointing device by which input and output can be executed between the control portion 30 and the operation portion 34, or a voice input portion. As the operation portion 34, a touch panel of the display portion 33 or a physical button provided on a housing may be used. The operation portion 34 notifies a control portion 20 of information regarding an operation by a user.

### A configuration of the server apparatus 2 will be described later.

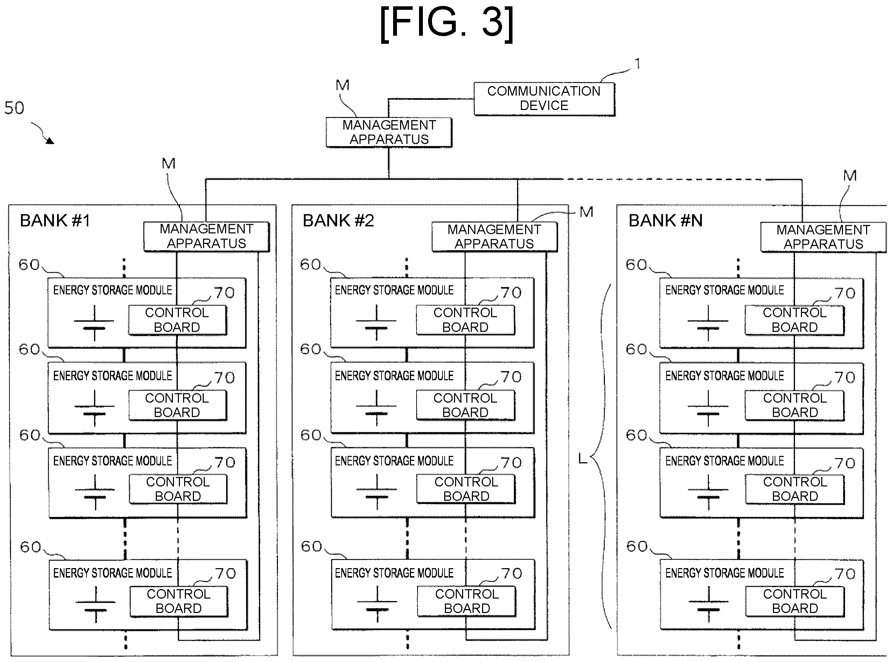

FIG. 3 is a diagram showing an example of a connection form of the communication device 1. As illustrated in FIG. 3, the communication device 1 is connected to a management apparatus M. Management apparatuses M respectively provided in banks #1 to #N are further connected to the management apparatus M. The communication device 1 may be a terminal device (a measurement monitor) which communicates with the management apparatus M provided in each of the banks #1 to #N and receives information on the energy storage device (energy storage module, energy storage cell), or may be a network card type communication device which can also be connected to a power-supply-related apparatus (power conditioner, uninterruptible power supply (UPS), rectifier).

Each of the banks #1 to #N includes a plurality of energy storage modules 60, and each of the energy storage modules 60 includes a control board (Cell Management Unit [CMU]) 70. The management apparatus M provided for each bank can communicate with the control board 70 equipped with a communication function incorporated in each of the energy storage modules 60 by serial communication, and can also transmit and receive information to and from the management apparatus M connected to the communication device 1. The management apparatus M connected to the communication device 1 aggregates information from the management apparatuses M of the banks belonging to a domain, and outputs the aggregated information to the communication device 1. A group L of a plurality of energy storage modules connected in series, which constitutes the bank, may be a target of evaluation or transaction aimed for reuse.

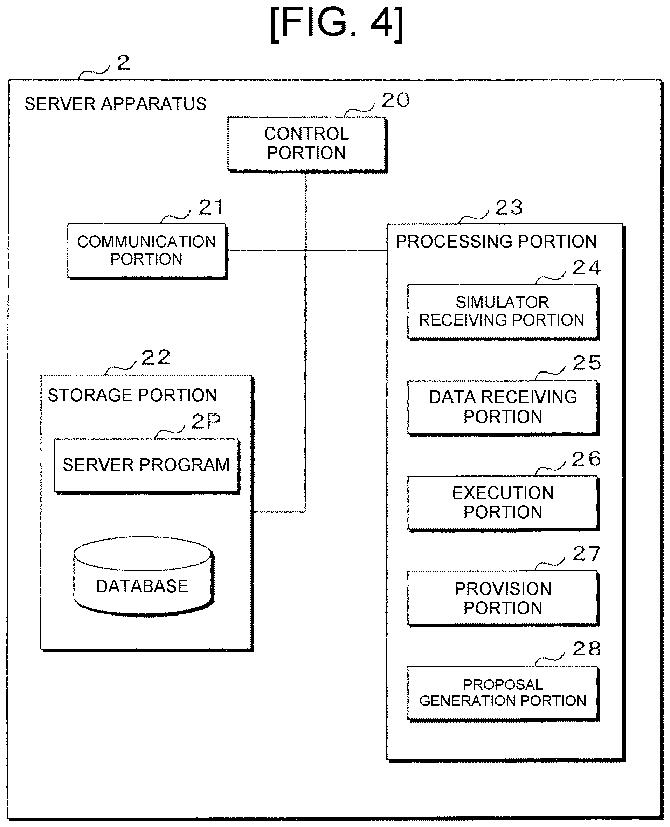

FIG. 4 is a block diagram showing an example of a configuration of the server apparatus 2. The server apparatus 2 includes the control portion 20, a communication portion 21, a storage portion 22, and a processing portion 23. The processing portion 23 includes a simulator receiving portion 24, a data receiving portion 25, an execution portion 26, a provision portion 27, and a proposal generation portion 28. The server apparatus 2 may be a single server computer but is not limited thereto, and may be configured by a plurality of server computers, for example, by cloud computing to provide a cloud service.

The control portion 20 can be configured by, for example, a CPU, and controls the server apparatus 2 as a whole by using built-in memories such as the ROM and the RAM. The control portion 20 executes information processing based on a server program 2P which is stored in the storage portion 22. The server program 2P includes a Web server program, and the control portion 20 functions as a web server which executes provision of a web page to the client apparatus 3, acceptance of a login to a web service, and the like. The control portion 20 can also collect, on the basis of the server program 2P, information from the communication devices 1 as a server for Simple Network Management Protocol (SNMP).

The communication portion 21 is a communication device which realizes communication connection and transmission and reception of data via the network N. Specifically, the communication portion 21 is a network card adapted to the network N (see FIG. 2).

As the storage portion 22, for example, a nonvolatile memory such as a hard disk or a flash memory may be used. In the storage portion 22, pieces of information on the respective energy storage apparatuses collected by the processing of the control portion 20 are stored.

The simulator receiving portion 24 of the processing portion 23 receives a simulator from a battery manufacturer, and the data receiving portion 25 receives operational history data from the communication device of each of the energy storage apparatuses (see FIG. 1). The received simulator and operational history data are stored in a database of the storage portion 22.

The execution portion 26 reads the corresponding simulator and operational history data from the database, inputs the operational history data to the read simulator to simulate the state of the battery at a predetermined point of time, and stores the simulated state in the database as a battery state file in association with each battery.

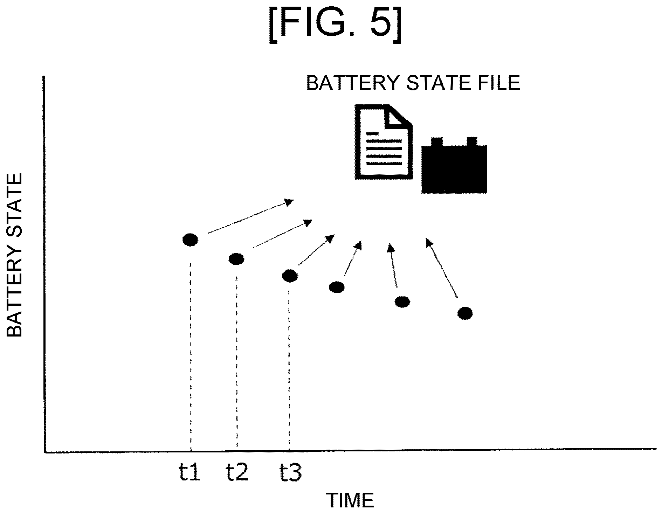

As illustrated in FIG. 5, the battery state file is periodically updated and saved in the database. At time t1, a battery state (a digital twin), which has been simulated by inputting operational history data representing the operational history of up to that time, is generated as the battery state file. Depending on in what environment and how the batteries have been charged and discharged up to the point of time t1, pieces of data in the battery state file will be different.

For example, deterioration resulting from operation of a lithium-ion battery includes various modes such as isolation of active material particles, a decrease in charge carriers (carriers of charges existing in a solid phase or a liquid phase, more specifically, lithium ions (Li+)) which are involved in a charge and a discharge, an increase in electrical resistance, and a reduction in conductivity in an electrolytic solution.

The isolation of the active material particles is a phenomenon in which the active material particles are cracked by repeated expansion and contraction due to a charge and a discharge, and a region in which desorption and insertion of charge carriers cannot be performed gradually increases, and thus a portion of the active material particles in which charge carriers can be occluded decreases, so that an amount of electricity that can be stored (that is, battery capacity) decreases.

The decrease in the charge carriers is a phenomenon in which ions in the electrolytic solution are lost due to a side reaction at a surface of an electrode during the charge.

The increase in the electrical resistance resulting from the operation of the lithium-ion battery is caused by a peel between current collector foil and the electrode, a break in a conductive assistant agent conductive path, formation of a resistor film, and the like. The reduction in the conductivity in the electrolytic solution is caused by a loss of the charge carriers, generation of minute bubbles in an electrode body, a change in a molecular structure of a solvate, clogging of a separator, and the like.

It is difficult to ascertain the details of a deteriorated state of a battery by merely measuring the battery capacity by conducting a discharge test of the battery at time t1. Meanwhile, at time t1, as operational history data representing the operational history of up to that time is input to the simulator provided by the battery manufacturer, a battery state file appropriately reflecting the deteriorated state is generated. In what environment and how the battery has been charged and discharged up to the point of time t1 are reflected in the data of the battery state file.

At time t2, the battery state file generated at time t1 is updated in accordance with the environment and the way in which the charge and discharge have been conducted from time t1 to time t2. Similarly, at time t3, the battery state file updated at time t2 is further updated in accordance with the operational history data representing the operational history from time t2 to time t3.

At time t2 or t3, operational history data representing all of the operational histories of up to that time is not used, but differential data representing a difference from the previous timing (t1 or t2) is used. Therefore, calculation can be performed speedily and a calculation load is light. In this way, the battery state file is sequentially updated.

As illustrated in FIG. 1, the battery state file is sequentially updated and held in the battery reuse assistance apparatus (server apparatus) 2. The owner or the administrator of the energy storage apparatuses 50a and 50b can download a battery state file corresponding to the energy storage apparatus of its own by using the client apparatus 3 (see FIG. 2), or obtain necessary data (the state, the present value in a reuse market, etc.) from the battery state file by using an evaluator which will be described later.

The battery reuse assistance apparatus 2 may be released to a plurality of manufacturers (a new product provider and a simulator provider) to whom access (an upload of a simulator, for example) is permitted, and be able to receive a simulator (a mathematical model, for example) of a battery from the plurality of manufacturers via the network N. The battery reuse assistance apparatus 2 may be able to receive a change in the uploaded simulator from the manufacturer.

The battery reuse assistance apparatus 2 may be released to a plurality of owners or administrators (current users), and be able to periodically and automatically receive the operational history data of each of the energy storage apparatuses 50a and 50b via the network N.

The battery reuse assistance apparatus 2 may be released to a plurality of potential purchasers or intermediate agents (third parties who are interested in reuse) to whom access is permitted, and be able to receive the supposed reuse operational data via the network N.

The provision portion 27 of the processing portion 23 illustrated in FIG. 4 provides, in response to a request from the client apparatus 3 (see FIG. 2) or as an event, the battery state file, information based on the simulator and the battery state file, or information based on the simulator, the battery state file, and the supposed reuse operational data. The event may be arrival of a periodic cycle or detection of a change in the state of a system or an apparatus such as occurrence of abnormality.

The proposal generation portion 28 of the processing portion 23 illustrated in FIG. 4 may propose an appropriate reuse application corresponding to the battery state to the owner of the energy storage apparatuses 50a and 50b (see FIG. 1). The term "reuse" in the present specification refers to diversion of the energy storage apparatus (for example, an energy storage pack or an energy storage module) to a secondary use without dissembling the energy storage apparatus to a level of the energy storage cells.

For example, if the main factor of the deterioration of a battery in the energy storage apparatus is isolation of the active material particles, a reuse application in which the battery is charged and discharged at a low rate is proposed. If the main factor of the deterioration of a battery is a decrease in the charge carriers, using the battery for an auxiliary power source such as a UPS is proposed as the reuse application.

If a platform for promoting the battery reuse as indicated in FIG. 1 is provided, the current user and the third party can access the battery state file as a digital twin for each of the energy storage apparatuses to grasp and determine a transaction price of a reused battery. Consequently, reuse of the battery is promoted. A new evaluation factor/evaluation axis which is different from confirmation of the performance of the battery itself (capacity measurement or the like) is provided to the party involved.

It is preferable that the past operational history data should not be traceable from the battery state file. By this feature, in what environment and how the battery has been charged and discharged by the previous user and the current user are concealed. This can prevent leakage of information related to know-how of the previous user and the current user.

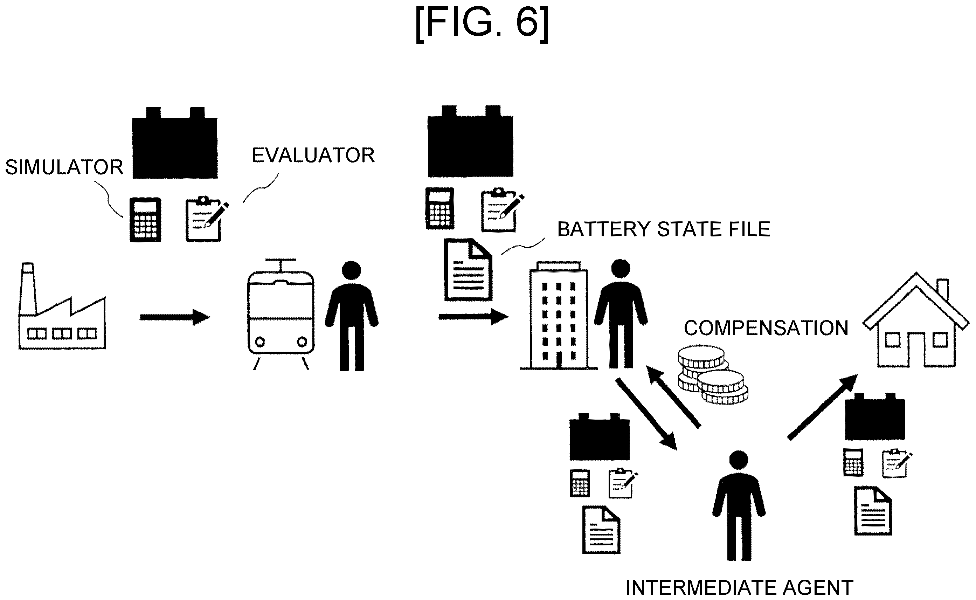

Further, as illustrated in FIG. 6, the simulator and the battery state file can be distributed together with the battery. FIG. 6 shows the way in which the evaluator is distributed together with the simulator. The evaluator is implemented by the execution portion 26 (see FIG. 4) in the server apparatus 2, for example, and is a function (a service, for example) which is provided by an operator (a platformer) of the battery reuse assistance apparatus, not by a manufacturer. The evaluator evaluates an operation method of the battery and the value of the battery on the basis of the operational history, the battery state, and information needs from the owner, the administrator, or the third party. For example, the evaluator evaluates whether or not the battery is deteriorated more than expected as compared with the expected life, or evaluates whether or not the current operation contributes to prolonging the life of the battery. The evaluator may calculate a selling reference price of the energy storage apparatus from the battery state or the number of accesses (the number of inquiries) from the third party. It is preferable that the platformer should compare the operational history with output information of the simulator, and an error or uncertainty of the output should be reflected in the evaluation by the evaluator. The current user of the battery may be changed through a sales contract or a transfer contract while the simulator, the evaluator, and the battery state file are being left in the battery reuse assistance apparatus 2 (see FIG. 1).

A guaranteed range of the reused battery is restricted to the estimation accuracy (accuracy of the digital twin) of the battery state through the simulator, and thus, the manufacturer indicated on a left side of FIG. 6 can concentrate their resources on the development of the batteries and simulators.

Embodiments are summarized below. The present invention is not limited to these embodiments. The battery is not limited to a lithium ion-battery, and may be another secondary battery.
(1) A battery reuse assistance apparatus includes: a simulator receiving portion which receives a simulator for simulating a state of a battery; a data receiving portion which receives operational history data at a predetermined point of time of the battery; an execution portion which simulates the state of the battery by inputting the operational history data to the simulator; a storage portion which stores the state which has been simulated as a battery state file at the predetermined point of time in association with the battery; and a provision portion which provides, in response to a request or as an event, the battery state file or information based on the simulator, the battery state file, and supposed reuse operational data.
   According to the above configuration, it is possible to construct an ecosystem capable of promoting reuse of a battery. By virtue of the simulator and the battery state file, it is possible to improve transparency of the transaction price and reliability of the battery after reuse is started. By causing the simulator, together with the battery state file, to be held in the battery reuse assistance apparatus which can be accessed by a plurality of entities, and not in an edge computer or a local computer, the battery reuse ecosystem can be smoothly operated.
(2) In the battery reuse assistance apparatus according to (1) described above, the data receiving portion may periodically and automatically receive the operational history data from a network-connected communication device of the battery.
   With the above-described configuration, the battery state file can be constantly updated at a low additional cost, and reliability of the battery state file and information obtained therefrom can be improved. Further, a speed of response to the information request can be improved.
(3) In the battery reuse assistance apparatus according to (1) or (2) described above, the simulator receiving portion may receive the simulator from a plurality of simulator providers.

With the above-described configuration, the manufacturers can devote themselves to being a new product provider and a simulator provider. The manufacturers are exempted from jobs such as searching for a reuse application and dealing with the current user or the third party regarding the reuse, and can concentrate their resources on the development of the batteries and simulators as described above.

The current user and the third party can smoothly perform the operation of the battery as an asset (for example, optimization of the possessed asset) including a reuse application search and a battery transfer timing, on the basis of a behavior of the battery indirectly guaranteed through the simulator.

As a countermeasure against the problem of depletion of resources, reusing the batteries such as lithium-ion batteries is desired. However, a trading market and a determination process of the transaction price of the batteries are yet to be established.

With the above-described configuration, it is possible to construct a platform on which a plurality of manufacturers, current users, and third parties can easily participate.

(4) A battery reuse assistance terminal includes a communication portion for connecting, via a network, to a battery reuse assistance apparatus holding a simulator and a battery state file, and the communication portion transmits supposed reuse operational data to the battery reuse assistance apparatus, and receives a simulation result of a behavior of a battery after reuse is started.

With the above-described configuration, a potential purchaser or an intermediate agent can efficiently search for a battery matching a desired reuse application.

The battery reuse assistance terminal may cause a display portion to display a screen for receiving input of the supposed reuse operational data.

(5) A battery reuse assistance method is a method in which a battery reuse assistance apparatus: receives a simulator for simulating a state of a battery; receives operational history data at a predetermined point of time of the battery; simulates the state of the battery by inputting the operational history data to the simulator; stores the state which has been simulated as a battery state file at the predetermined point of time in association with the battery; and provides, in response to a request or as an event, the battery state file or information based on the simulator, the battery state file, and supposed reuse operational data.

(6) The battery reuse assistance method is a method in which a battery reuse assistance terminal transmits, via a communication portion for connecting via a network to a battery reuse assistance apparatus holding a simulator and a battery state file, supposed reuse operational data to the battery reuse assistance apparatus, and receives, via the communication portion, a simulation result of a behavior of a battery after reuse is started.

The method of (5) and (6) described above may be implemented by a computer program (a server program or a Web browser program, for example).

### DESCRIPTION OF REFERENCE NUMERALS

2 Server apparatus (battery reuse assistance apparatus)
3 Client apparatus (battery reuse assistance terminal)
24 Simulator receiving portion
25 Data receiving portion
26 Execution portion
27 Provision portion
50 Energy storage apparatus (battery)
100 Battery reuse ecosystem

## Claims

1. A battery reuse assistance apparatus comprising:
a simulator receiving portion which receives a simulator for simulating a state of a battery;
a data receiving portion which receives operational history data at a predetermined point of time of the battery;
an execution portion which simulates the state of the battery by inputting the operational history data to the simulator;
a storage portion which stores the state which has been simulated as a battery state file at the predetermined point of time in association with the battery; and
a provision portion which provides, in response to a request or as an event, the battery state file or information based on the simulator, the battery state file, and supposed reuse operational data.

2. The battery reuse assistance apparatus according to claim 1, wherein the data receiving portion periodically and automatically receives the operational history data from a network-connected communication device of the battery.

3. The battery reuse assistance apparatus according to claim 1 or 2, wherein the simulator receiving portion receives the simulator from a plurality of simulator providers.

4. A battery reuse assistance terminal comprising a communication portion for connecting, via a network, to a battery reuse assistance apparatus holding a simulator and a battery state file, wherein
the communication portion transmits supposed reuse operational data to the battery reuse assistance apparatus, and receives a simulation result of a behavior of a battery after reuse is started.

5. A battery reuse assistance method in which a battery reuse assistance apparatus executes the battery reuse assistance method comprising:
receiving a simulator for simulating a state of a battery;
receiving operational history data at a predetermined point of time of the battery;
simulating the state of the battery by inputting the operational history data to the simulator;
storing the state which has been simulated as a battery state file at the predetermined point of time in association with the battery; and
providing, in response to a request or as an event, the battery state file or information based on the simulator, the battery state file, and supposed reuse operational data.

6. A battery reuse assistance method in which a battery reuse assistance terminal executes the battery reuse assistance method comprising:
transmitting, via a communication portion for connecting via a network to a battery reuse assistance apparatus holding a simulator and a battery state file, supposed reuse operational data to the battery reuse assistance apparatus; and
receiving, via the communication portion, a simulation result of a behavior of a battery after reuse is started.
